# FASCICULE DE BREVET EUROPEEN

(11) **EP 1 715 520 B1**
(45) Date de publication et mention de la délivrance du brevet: **03.03.2010**
(21) Numéro de dépôt: 06112855.9
(22) Date de dépôt: 20.04.2006
(51) Int. Cl.: H01L 23/552, H05K 1/02, H05K 9/00

(54) **Dispositif de protection d'un circuit électronique**
Vorrichtung zum Schutz einer elektronischen Schaltung
Device for protecting an electronic circuit

(30) Priorité: 21.04.2005 FR 0551018
(43) Date de publication de la demande: 25.10.2006
(73) Titulaire: ST MICROELECTRONICS S.A., 92120 Montrouge (FR)
(72) Inventeur: Coffy, Romain, 38700 La Tronche (FR)
(74) Mandataire: de Beaumont, Michel

(56) Documents cités:
- DE-A1- 10 065 896
- US-A- 5 639 989
- US-A- 5 694 300
- US-A1- 2005 056 925

## Description

### Domaine de l'invention

La présente invention concerne un dispositif de protection d'un circuit électronique et un procédé de réalisation d'un tel dispositif.

### Exposé de l'art antérieur

De nombreux circuits électroniques, par exemple pour téléphone mobile, sont réalisés en fixant à un support principal, généralement appelé carte mère, des circuits électroniques élémentaires réalisés séparément et remplissant chacun une fonction spécifique. A titre d'exemple, pour un téléphone mobile, un circuit électronique élémentaire correspond à un circuit émetteur/récepteur radio, destiné à être relié à l'antenne du téléphone mobile, et qui effectue la démodulation des signaux reçus au niveau de l'antenne et la modulation des signaux à émettre. Un autre circuit électronique élémentaire correspond à un circuit amplificateur de puissance et permet l'amplification des signaux à émettre fournis par le circuit émetteur/récepteur radio. Chaque circuit électronique élémentaire est réalisé sur un support distinct, par exemple un boîtier à billes (appelé également boîtier BGA de l'anglais Ball Grid Array) ou un boîtier LGA (de l'anglais Land Grid Array).

Certains circuits électroniques élémentaires peuvent être sensibles aux perturbations électromagnétiques. C'est le cas, par exemple, du circuit émetteur/récepteur radio d'un téléphone mobile qui est généralement fixé à la carte mère, comme le circuit amplificateur de puissance, à proximité de l'antenne. En particulier, le bon fonctionnement du circuit émetteur/récepteur radio peut être gêné par les perturbations électromagnétiques émises par le circuit amplificateur de puissance et d'autres circuits extérieurs.

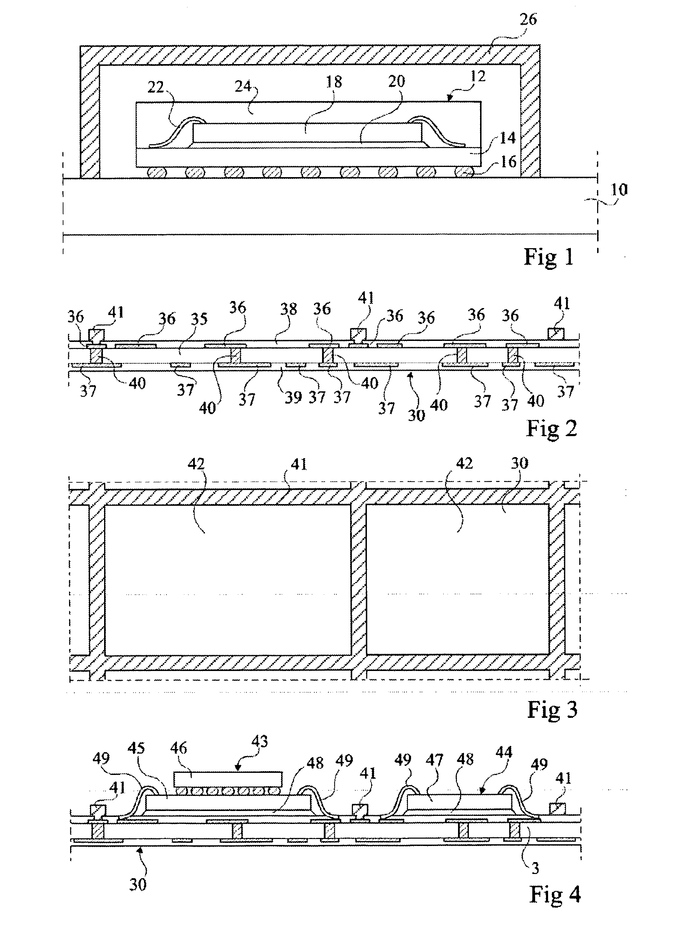

La figure 1 représente un exemple classique de protection d'un circuit électronique élémentaire contre les perturbations électromagnétiques. En figure 1, on a représenté, en coupe, une portion d'une carte mère 10 sur laquelle est soudé un circuit électronique élémentaire 12. A titre d'exemple, le circuit électronique élémentaire 12 est constitué d'un boîtier BGA 14, soudé à la carte mère 10 par l'intermédiaire de billes de soudure 16. Le circuit électronique élémentaire 12 comprend un circuit intégré 18, fixé au boîtier 14 par une couche de colle 20. Des fils électriques 22, par exemple en or, assurent une connexion électrique entre la puce 18 et le boîtier BGA 14. Un bloc de résine 24 recouvre le circuit intégré 18 et le protège contre les chocs mécaniques.

Afin de protéger le circuit intégré 18 contre les perturbations électromagnétiques, on prévoit un couvercle métallique 26, soudé à la carte mère 10 et qui encapsule le circuit 12. Le couvercle 26 est relié à la masse par l'intermédiaire de la carte mère 10. De façon générale, il est nécessaire de prévoir un couvercle métallique, tel que décrit en figure 1, pour chaque circuit électronique élémentaire devant être protégé contre les perturbations électromagnétiques.

Une tendance actuelle est à l'intégration sur un même circuit électronique élémentaire de plusieurs fonctions auparavant réalisées par des circuits élémentaires distincts. A titre d'exemple, en téléphonie mobile, il peut être souhaitable de réaliser un circuit électronique élémentaire unique qui intègre les fonctions auparavant réalisées par le circuit émetteur/récepteur et le circuit amplificateur de puissance. Ceci peut être obtenu en disposant plusieurs circuits intégrés sur un même boîtier BGA, un même boîtier LGA ou un autre type de boîtier.

Une difficulté consiste alors à protéger certains constituants d'un tel circuit électronique élémentaire contre les perturbations électromagnétiques émises par d'autres constituants du même circuit électronique élémentaire. En effet, la mise en place de couvercles métalliques directement au niveau du circuit électronique élémentaire est généralement incompatible avec les procédés classiques de fabrication de tels circuits.

Le document US 5 694 300 décrit un dispositif de protection d'un circuit électronique contre les perturbations électromagnétiques comprenant un support auquel sont fixées au moins deux portions de circuit, comportant chacune au moins une puce de circuit intégré. Chaque portion de circuit est recouverte d'un bloc isolant, lui-même recouvert d'une couche métallique reliée au support. Le document DE 100 65 896 décrit un dispositif de protection d'un circuit électronique contre les perturbations électromagnétiques.

### Résumé de l'invention

La présente invention vise à protéger une portion d'un circuit électronique, comprenant au moins un circuit intégré, contre les perturbations électromagnétiques émises par une autre portion, comprenant au moins un autre circuit intégré, du même circuit électronique et contre les perturbations électromagnétiques émises par d'autres circuits électroniques.

Selon un autre objet de la présente invention, le procédé de protection est compatible avec les procédés de fabrication actuels de circuits électroniques.

Selon un autre objet de la présente invention, le procédé de protection modifie peu les étapes d'un procédé de fabrication classique de circuits électroniques.

Pour atteindre ces objets, la présente invention prévoit un dispositif de protection d'un circuit électronique contre les perturbations électromagnétiques comprenant un support auquel sont fixées au moins deux portions de circuit, comportant chacune au moins une puce de circuit intégré. Chaque portion de circuit est recouverte d'un bloc isolant, lui-même recouvert d'une couche métallique reliée au support. Le dispositif comprend des bandes conductrices fixées au support et entourant chaque portion de circuit, les couches métalliques étant connectées au support par l'intermédiaire des bandes conductrices.

Selon un mode de réalisation de l'invention, le support est destiné à être fixé à une base, le support comprenant des moyens de connexion électrique des couches métalliques à une borne au potentiel de référence de la base.

Selon un mode de réalisation de l'invention, le support comprend une portion plane isolante et des moyens, contenus dans la portion plane, pour connecter des premières pistes conductrices disposées sur une face de la portion plane et des secondes pistes conductrices disposées sur la face opposée, les bandes conductrices étant en contact avec au moins une piste conductrice, parmi les premières pistes conductrices, connectée à une piste conductrice, parmi les secondes pistes conductrices, destinée à être reliée à une source d'un potentiel de référence.

Selon un mode de réalisation de l'invention, les couches métalliques ont au moins une paroi commune.

Selon un mode de réalisation de l'invention, les couches métalliques ont des parois en vis-à-vis.

Selon un mode de réalisation de l'invention, le support est un boîtier à billes.

La présente invention vise également un procédé de fabrication d'un circuit électronique protégé contre les perturbations électromagnétiques comprenant les étapes suivantes :
(a) prévoir une plaque ;
(b) fixer à la plaque des portions de circuit contenant chacune au moins une puce de circuit intégré ;
(c) couvrir d'une couche isolante ;
(d) former, dans la couche isolante, des évidements qui entourent chaque portion de circuit et délimitent un bloc isolant recouvrant chaque portion de circuit ;
(e) recouvrir la structure obtenue d'une couche métallique ; et
(f) délimiter des circuits électroniques comportant chacun au moins deux portions de circuits adjacentes,
   l'étape (b) étant précédée ou suivie d'une étape de formation de bandes conductrices sur le support entourant chaque portion de circuit, les évidements étant formés à l'étape (d) de façon à exposer les bandes conductrices, d'où il résulte, qu'à l'étape (e), la couche métallique est en contact avec les bandes conductrices.

Selon un mode de réalisation de l'invention, les évidements sont réalisés par sciage.

### Brève description des dessins

Ces objets, caractéristiques et avantages, ainsi que d'autres de la présente invention seront exposés en détail dans la description suivante d'exemples de réalisation particuliers faite à titre non-limitatif en relation avec les figures jointes parmi lesquelles :
la figure 1, précédemment décrite, représente un dispositif classique de protection d'un circuit électronique, fixé à un support, contre les perturbations électromagnétiques ;
les figures 2 à 8 illustrent des étapes successives d'un premier exemple de réalisation de procédé de protection selon l'invention d'un circuit électronique contre les perturbations électromagnétiques ; et
les figures 9 à 13 illustrent des étapes successives d'un second exemple de réalisation du procédé de protection selon l'invention.

### Description détaillée

Par souci de clarté, de mêmes éléments ont été désignés par de mêmes références aux différentes figures et, de plus, comme cela est habituel dans la représentation des circuits intégrés, les diverses figures ne sont pas tracées à l'échelle.

Les figures 2 à 8 illustrent des étapes successives d'un premier exemple de réalisation de procédé de fabrication selon l'invention d'un circuit électronique protégé contre les perturbations.

La figure 2 est une coupe d'un support 30 à partir duquel peuvent être obtenus des boîtiers BGA sur lesquels seront formés des circuits électroniques. A une telle étape du procédé de fabrication, le support 30 a la forme d'une plaque constituée d'une couche centrale 35 en un matériau isolant. Des pistes métalliques 36, 37 sont disposées sur chaque face de la couche centrale 35 et sont recouvertes d'une couche isolante 38, 39. Des vias 40 métalliques sont formés dans la couche centrale 35, chaque via 40 connectant une piste métallique 36 disposée sur une face de la couche centrale 35 avec une piste métallique 37 disposée sur l'autre face de la couche centrale 35.

Les figures 2 et 3 sont respectivement une coupe et une vue de dessus de la structure obtenue après avoir gravé localement la couche isolante 38 pour exposer des portions de pistes métalliques 36 et après avoir formé sur le support 30 des bandes conductrices 41 en contact avec les pistes métalliques 36 exposées. En vue de dessus, les bandes conductrices 41 forment un quadrillage sur le support 30 délimitant des emplacements 42, un ou plusieurs circuits intégrés étant destinés à être fixés au support 30 au niveau de chaque emplacement 42. A titre d'exemple, les bandes conductrices 41 sont constituées d'une pâte à souder et ont une épaisseur d'environ 60 µm et une largeur d'une centaine de micromètres. A titre d'exemple, les bandes conductrices 41 peuvent être réalisées en étalant de la pâte à souder sur un masque disposé en vis-à-vis du support 30. Dans ce cas, les bandes conductrices 41 peuvent être localement interrompues pour faciliter la réalisation d'un tel masque. Lorsque des ouvertures sont présentes au niveau des bandes conductrices 41, le nombre et les dimensions de telles ouvertures dépendent de la nature des perturbations électromagnétiques attendues.

Parallèlement à la formation des bandes conductrices 41, des plots isolés (non représentés) de pâte à souder peuvent être formés sur le support 30, de tels plots étant en contact avec des pistes métalliques 36. De tels plots isolés permettent, de façon classique, la mise en place de composants électroniques discrets, généralement appelés CMS (Composant Monté en Surface correspondant à l'expression anglaise Surface Mounted Device ou SMD). De tels composants correspondent, par exemple, à des condensateurs ou à des résistances qui ne peuvent pas être réalisés de façon intégrée.

La figure 4 est une coupe de la structure obtenue après fixation de circuits électroniques 43, 44 au niveau des emplacements 42. En figure 4, les deux circuits 43, 44 représentés sont fixés au niveau de deux emplacements 42 adjacents et sont destinés, à la fin du procédé de fabrication, à se trouver sur une même portion du support 30. Toutefois, à la présente étape du procédé de fabrication, les circuits 43, 44 sont reproduits en de nombreux exemplaires sur le support 30. A titre d'exemple, le circuit 43 est un circuit émetteur/récepteur constitué d'une première puce de circuit intégré 45 et d'une seconde puce de circuit intégré 46 fixée à la première puce de circuit intégré 45 selon une liaison de type flip/chip et le circuit 44 est un circuit amplificateur de puissance constitué d'une puce de circuit intégré 47. La fixation des circuits 43, 44 au support 30 est obtenue en déposant des portions de colle 48 sur le support 30, en posant les circuits 43, 44 au niveau des portions de colle 48, et en faisant polymériser les portions de colle 48. Les connexions électriques entre les circuits 43, 44 et le support 30 sont obtenues par l'intermédiaire de fils électriques 49, par exemple en or, connectés à des pistes métalliques 36 au travers de la couche isolante 38. Il est clair que les structures des circuits 43, 44 sont données à simple titre d'illustration, les circuits 43, 44 pouvant comprendre un nombre plus ou moins important de puces de circuit intégré.

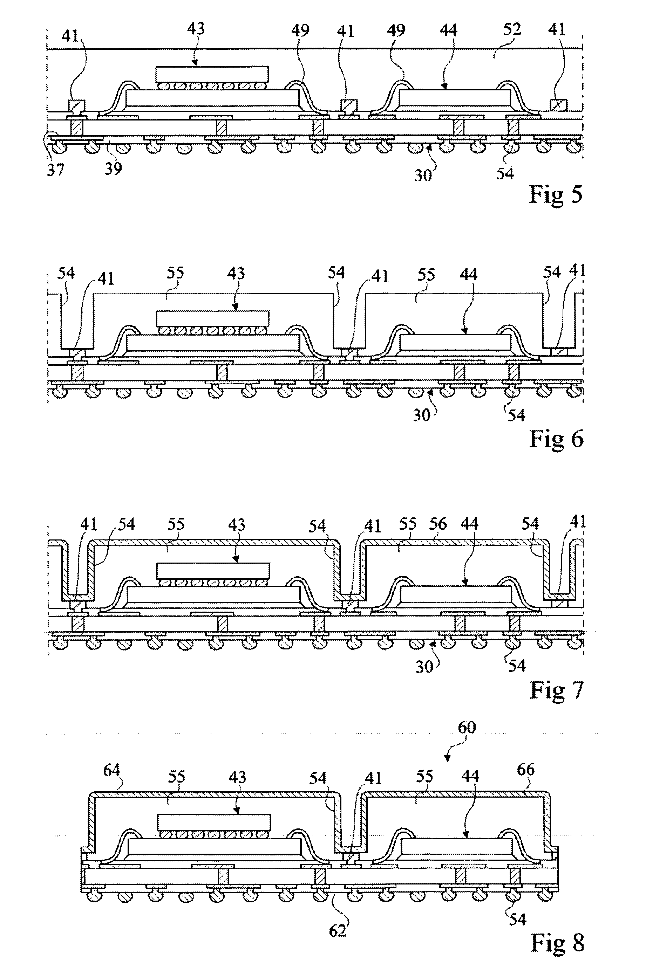

La figure 5 illustre le circuit obtenu après avoir déposé une couche de résine 52, par exemple une résine époxy, sur le support 30 et les circuits électroniques 43, 44 et après avoir formé des billes de soudure 54, par exemple en étain, sur la face du support 30 opposée aux circuits 43, 44. A titre d'exemple, la couche de résine 52 a une épaisseur d'environ 0,8 mm. Certaines billes de soudure 54 sont connectées à des pistes métalliques 37 du support 30, à travers la couche de résine 39, permettant la réalisation de connexions électriques entre des billes de soudure 54 et des fils électriques 49 et entre des billes de soudure 54 et les bandes conductrices 41.

La figure 6 représente la structure obtenue après avoir réalisé des évidements 54 dans la couche de résine 52 exposant la portion supérieure des bandes conductrices 41. Les évidements 54 suivent donc la répartition des bandes conductrices 41 et délimitent des blocs de résine 55 distincts au niveau de chaque circuit 43, 44. Les évidements 54 ont une largeur supérieure à la largeur des bandes conductrices 41. A titre d'exemple, les évidements 54 peuvent être réalisés par sciage de la couche de résine 52 sur une partie de la profondeur de la couche de résine 52, par exemple au moyen d'une scie circulaire ayant une épaisseur d'environ 250 µm. En figure 6, les évidements 54 sont représentés avec une section constante. Selon une variante de réalisation, les évidements 54 ont une section comprenant plusieurs paliers successifs ou une section en "V", le fond d'un évidement 54 exposant la portion supérieure d'une bande conductrice 41.

La figure 7 illustre la structure obtenue après avoir recouvert les blocs de résine 55 d'une couche métallique 56 qui pénètre dans les évidements 54 et vient au contact des bandes conductrices 41. La couche métallique 56 peut être réalisée par un dépôt métallique, par exemple par une pulvérisation cathodique. Le métal constituant la couche métallique 56 peut être de l'or ou de l'argent. De façon générale, il s'agit d'un métal ou d'un alliage métallique faiblement oxydable ou dont l'oxydation dégrade peu les propriétés de conduction. L'épaisseur de la couche métallique 56, de l'ordre de quelques micromètres, dépend du matériau utilisé et de la nature des perturbations électromagnétiques contre lesquelles on souhaite obtenir une protection. En outre, l'épaisseur de la couche métallique 56 peut ne pas être constante, en particulier au niveau des évidements 54.

Selon une variante de réalisation de la présente invention, après le dépôt de la couche métallique 56, on prévoit une étape supplémentaire de remplissage des évidements 54 par un matériau isolant, par exemple une résine. Selon une autre variante de réalisation, les évidements 54 sont complètement remplis de métal.

La figure 8 représente la structure obtenue après découpe du support 30, de certaines bandes conductrices 41 et de la couche métallique 56 pour obtenir des circuits électroniques 60 distincts, un seul circuit 60 étant représenté. Chaque circuit électronique 60 est constitué, dans le présent exemple, d'une portion 62 du support 30 sur laquelle sont fixés les circuits 43 et 44, chaque circuit étant complètement entouré d'une cage métallique 64, 66 correspondant à une portion de la couche métallique 56. La découpe des circuits 60 peut être réalisée au moyen d'une scie circulaire dont l'épaisseur est inférieure à l'épaisseur de la scie circulaire utilisée pour réaliser les évidements 54, par exemple de l'ordre de 100 µm.

Le circuit électronique 60 est, par exemple, destiné à être fixé à une carte mère. Les cages métalliques 64, 66 peuvent alors être mises à la masse par l'intermédiaire des bandes conductrices 41 connectées à des billes de soudure 54, elles-mêmes reliées la masse par l'intermédiaire de la carte mère. Chaque cage métallique 64, 66 protège alors le circuit électronique 43, 44 qu'elle contient contre les perturbations électromagnétiques extérieures, notamment les perturbations électromagnétiques émises par l'autre circuit 43, 44 fixé à la même portion 62 du support 30.

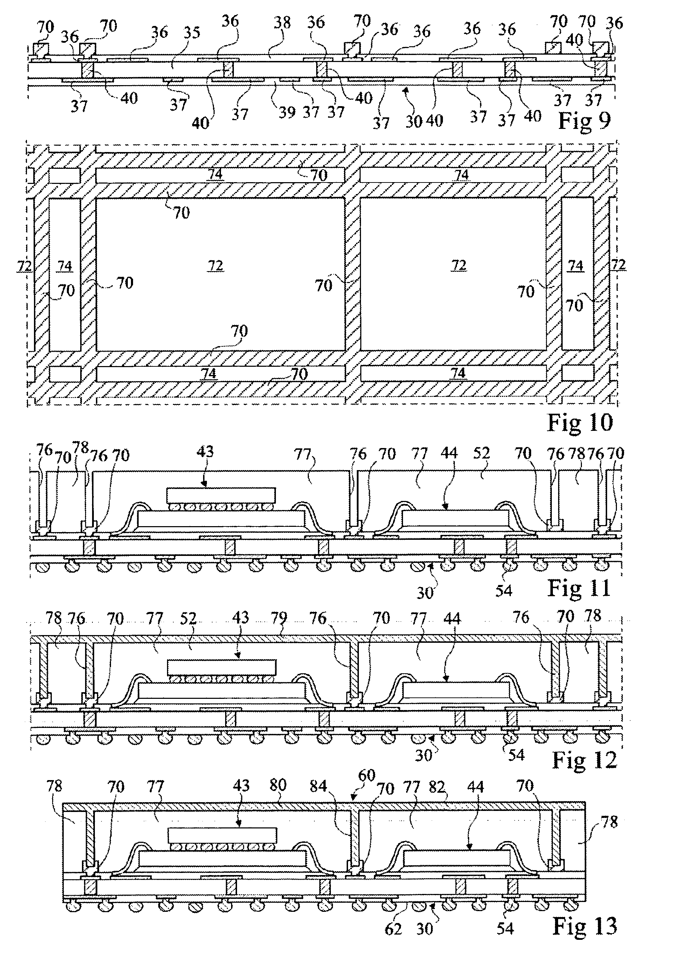

Les figures 9 à 13 illustrent des étapes successives d'un second exemple de réalisation de procédé de protection selon l'invention.

Les figures 9 et 10 sont analogues aux figures 2 et 3 dans la mesure où des bandes conductrices 70 sont réparties sur le support 30 sous la forme d'un quadrillage qui délimite des emplacements 72. Comme pour le premier exemple de réalisation, deux emplacements 72 adjacents au niveau desquels seront fixés des circuits destinés à se trouver sur une même portion de support 30 sont séparés par une seule bande conductrice 70. Toutefois, à la différence du premier exemple de réalisation, deux emplacements 72 adjacents au niveau desquels seront fixés des circuits destinés à se trouver sur deux portions de support 30 distinctes sont séparés par deux bandes conductrices 70 parallèles, séparées d'un intervalle 74.

Les étapes suivantes de fixation des circuits 43, 44 et de dépôt de la couche de résine 52 sont identiques à ce qui a été précédemment décrit pour le premier exemple de réalisation.

La figure 11 représente la structure obtenue après avoir réalisé des évidements 76 dans la couche de résine 52 pénétrant partiellement dans les bandes conductrices 70. Les évidements 76 suivent donc la répartition des bandes conductrices 70 et délimitent des blocs de résine 77 au niveau de chaque circuit 43, 44 et des blocs de résine 78 au niveau des intervalles 74 entre deux bandes conductrices 70 adjacentes. A titre d'exemple, les évidements 76 peuvent être réalisés par sciage de la couche de résine 52 sur une partie de la profondeur de la couche de résine 52, par exemple au moyen d'une scie circulaire ayant une épaisseur d'environ 100 µm.

La figure 12 illustre la structure obtenue après avoir recouvert les blocs de résine 77, 78 d'une couche métallique 79 qui pénètre dans les évidements 76 et vient au contact des bandes conductrices 70. La détermination de l'épaisseur et de la nature de la couche métallique 79 suit les considérations décrites précédemment pour la couche métallique 56.

La figure 13 représente la structure obtenue après découpe du support 30, des blocs de résine 78 et de la couche métallique 79 pour obtenir des circuits électroniques 60 distincts, un seul circuit 60 étant représenté. La découpe du support 30 peut être réalisée au moyen d'une scie circulaire dont l'épaisseur est, par exemple, de l'ordre de 100 µm. La découpe est réalisée au niveau des intervalles 74, entre deux bandes conductrices 70 adjacentes. Comme pour le premier exemple de réalisation, chaque circuit électronique 60 est constitué d'une portion 62 du support 30 sur laquelle sont fixés les circuits 43 et 44, chaque circuit étant entouré d'une cage métallique 80, 82 correspondant à une portion de la couche métallique 78. Dans le second exemple de réalisation, les cages métalliques 80, 82 ont une paroi commune 84 entre les deux circuits 43, 44.

Pour les deux exemples de réalisation précédemment décrits, la protection des circuits 43, 44 réalisés sur la même portion 62 du support 30 étant réalisée par les cages métalliques 64, 66, 80, 82, il n'est alors plus nécessaire, lorsque la portion 62 de support est fixée par la suite à une carte mère, de prévoir un couvercle métallique encapsulant la portion 62 de support, et qui de toute façon ne protègerait pas chaque circuit 43, 44 fixé à la portion 62 de support contre les perturbations électromagnétiques émises par l'autre circuit 43, 44 fixé à la même portion 62 de support. Pour un circuit 60 de dimensions données, la mise en oeuvre du dispositif de protection selon l'invention entraîne un encombrement moins important que celui qui résulte de l'utilisation d'un couvercle métallique distinct. En effet, l'encombrement du dispositif de protection selon la présente invention provient de l'ajout de la couche métallique 56, 79 dont l'épaisseur est généralement de l'ordre de quelques micromètres. Lorsqu'un couvercle métallique distinct est utilisé, il est généralement nécessaire de prévoir un espace libre supérieur au millimètre au-dessus du circuit 60 pour permettre la mise en place du couvercle métallique de protection.

De plus, la présente invention permet une mise convenable des cages métalliques 64, 66, 80, 82 à la masse de la carte mère. En effet, les bandes conductrices 41, 70 peuvent être connectées à des pistes conductrices 36 en de nombreux points répartis sur la totalité de leur longueur, et notamment au niveau de la bande conductrice qui sépare les circuits 43, 44, permettant une répartition équilibrée des potentiels.

Dans le premier exemple de réalisation, un espace libre peut, en outre, être laissé entre les cages métalliques 64, 66 qui ne sont alors en contact qu'au niveau de la bande conductrice 41 s'étendant entre les circuits 43, 44. Une telle structure permet, de façon avantageuse, que les blocs de résine 55 se déforment différemment. Une telle différence peut être due à des dilatations différentielles des blocs de résine 55 lorsque les quantités de chaleur libérées par les circuits 43, 44 sont différentes.

La présente invention prévoit un procédé de protection de circuits électroniques qui, de façon avantageuse, entraîne peu de modifications par rapport à un procédé classique de fabrication de circuits électroniques. En effet, la seule étape qui nécessite la mise en oeuvre de moyens spécifiques est l'étape de formation de la couche métallique 56, 79 sur la couche de résine 52. Les bandes conductrices 41, 70 peuvent être réalisées à l'étape, généralement déjà présente, de formation de plots destinés à être connectés à des composants discrets. En outre, l'étape de formation des évidements 54, 76 peut être mise en oeuvre par découpe au moyen d'une scie circulaire, un tel procédé de découpe étant déjà classiquement mis en oeuvre pour la délimitation des circuits 60 par découpe du support 30.

Bien entendu, la présente invention est susceptible de diverses variantes et modifications qui apparaîtront à l'homme de l'art. En particulier, la présente invention a été décrite pour la protection de circuits électroniques réalisés sur un même boîtier BGA. Toutefois, la présente invention concerne également la protection de circuits électroniques réalisés sur un même boîtier LGA et, de façon plus générale, la protection de circuits électroniques réalisés sur un même support.

## Revendications

1. Dispositif de protection d'un circuit électronique (60) contre les perturbations électromagnétiques comprenant un support (62) auquel sont fixées au moins deux portions de circuit (43, 44), comportant chacune au moins une puce de circuit intégré (45, 46, 47), chaque portion de circuit étant recouverte d'un bloc isolant (55 ; 77), lui-même recouvert d'une couche métallique (64, 66 ; 80, 82) reliée au support, **caractérisé en ce qu'**il comprend des bandes conductrices (41 ; 70) fixées au support (62) et entourant chaque portion de circuit (43, 44), les couches métalliques (64, 66 ; 80, 82) étant connectées au support par l'intermédiaire des bandes conductrices.

2. Dispositif selon la revendication 1, dans lequel le support (62) est destiné à être fixé à une base, le support (62) comprenant des moyens (36, 37, 40, 54) de connexion électrique des couches métalliques (64, 66 ; 80, 82) à une borne au potentiel de référence de la base.

3. Dispositif selon la revendication 1, dans lequel le support (62) comprend une portion plane isolante et des moyens (40), contenus dans la portion plane, pour connecter des premières pistes conductrices (36) disposées sur une face de la portion plane et des secondes pistes conductrices (37) disposées sur la face opposée, les bandes conductrices (41 ; 70) étant en contact avec au moins une piste conductrice, parmi les premières pistes conductrices, connectée à une piste conductrice, parmi les secondes pistes conductrices, destinée à être reliée à une source d'un potentiel de référence.

4. Dispositif selon la revendication 1, dans lequel les couches métalliques (64, 66 ; 80, 82) ont au moins une paroi commune.

5. Dispositif selon la revendication 1, dans lequel les couches métalliques (64, 66 ; 80, 82) ont des parois en vis-à-vis.

6. Dispositif selon la revendication 1, dans lequel le support (62) est un boîtier à billes.

7. Procédé de fabrication d'un circuit électronique (60) protégé contre les perturbations électromagnétiques comprenant les étapes suivante :
(a) prévoir une plaque (30) ;
(b) fixer à la plaque des portions de circuit (43, 44) contenant chacune au moins une puce de circuit intégré ;
(c) couvrir d'une couche isolante (52) ;
(d) former, dans la couche isolante, des évidements (54 ; 70) qui entourent chaque portion de circuit et délimitent un bloc isolant (55 ; 77) recouvrant chaque portion de circuit ;
(e) recouvrir la structure obtenue d'une couche métallique (56 ; 79) ; et
(f) délimiter des circuits électroniques comportant chacun au moins deux portions de circuits adjacentes,
**caractérisé en ce que** l'étape (b) est précédée ou suivie d'une étape de formation de bandes conductrices (41 ; 70) sur le support (30) entourant chaque portion de circuit (43, 44), les évidements (54 ; 70) étant formés à l'étape (d) de façon à exposer les bandes conductrices, d'où il résulte, qu'à l'étape (e), la couche métallique (56 ; 79) est en contact avec les bandes conductrices.

8. Procédé selon la revendication 7, dans lequel les évidements (54 ; 70) sont réalisés par sciage.

## Claims

1. A device for protecting an electronic circuit (60), comprising a support (62) to which are attached at least two circuit portions (43, 44), each comprising at least one integrated circuit chip (45, 46, 47), each circuit portion being covered with an insulating block (55; 77), itself covered with a metal layer (64, 66; 80, 82) connected to the support, **characterized in that** it comprises conductive strips (41; 70) attached to the support (62) and surrounding each circuit portion (43, 44), the metal layers (64, 66; 80, 82) being connected to the support via conductive strips.

2. The device of claim 1, wherein the support (62) is intended to be attached to a base, the support (62) comprising means (36, 37, 40, 54) of electric connection of the metal layers (64, 66; 80, 82) to a terminal at the base reference voltage.

3. The device of claim 1, wherein the support (62) comprises a planar insulating portion and means (40), contained in the planar portion, for connecting first conductive tracks (36) arranged on a surface of the planar portion and second conductive tracks (37) arranged on the opposite surface, the conductive strips (41; 70) being in contact with at least one conductive track, among the first conductive tracks, connected to a conductive track, among the second conductive tracks, intended to be connected to a source of a reference voltage.

4. The device of claim 1, wherein the metal layers (64, 66; 80, 82) have at least one common wall.

5. The device of claim 1, wherein the metal layers (64, 66; 80, 82) have opposite walls.

6. The device of claim 1, wherein the support (62) is a ball grid array.

7. A method for manufacturing an electronic circuit (60), comprising the steps of:
(a) providing a wafer (30);
(b) attaching to the wafer circuit portions (43, 44), each containing at least one integrated circuit chip;
(c) covering with an insulating layer (52);
(d) forming, in the insulating layer, recesses (54; 70) which surround each circuit portion and delimit an insulating block (55; 77) covering each circuit portion;
(e) covering the obtained structure with a metal layer (56; 79); and
(f) delimiting electronic circuits, each comprising at least two adjacent circuit portions,
**characterized in that** step (b) is preceded or followed by a step of forming conductive strips (41; 70) on the support (30) surrounding each circuit portion (43, 44), the recesses (54; 70) being formed at step (d) to expose the conductive strips, whereby, at step (e), the metal layer (56; 79) is in contact with the conductive strips.

8. The method of claim 7, wherein the recesses (54; 70) are formed by sawing.

## Patentansprüche

1. Vorrichtung zum Schützen eines elektronischen Schaltkreises (60), die einen Träger (62) aufweist, an dem wenigstens zwei Schaltkreisteile (43, 44) angebracht sind, wobei jeder wenigstens einen integrierten Schaltkreischip (45, 46, 47) aufweist, und wobei jeder Schaltkreisteil mit einem Isolationsblock (55; 77) abgedeckt ist, der selbst mit einer Metallschicht (64, 66; 80, 82) abgedeckt ist, welche mit dem Träger verbunden ist, **dadurch gekennzeichnet, dass** sie Leiterstreifen (41; 70) aufweist, die an dem Träger (62) angebracht sind und jeden Schaltkreisteil (43, 44) umgeben, wobei die Metallschichten (64, 66; 80, 82) mittels Leiterstreifen mit dem Träger verbunden sind.

2. Vorrichtung nach Anspruch 1, wobei der Träger (62) dafür vorgesehen ist an einer Basis befestigt zu sein, und wobei der Träger (62) Mittel (36, 37, 40, 54) aufweist zur elektrischen Verbindung der Metallschichten (64, 66; 80, 82) mit einem Anschluss an der Basisreferenzspannung.

3. Vorrichtung nach Anspruch 1, wobei der Träger (62) einen ebenen Isollationsteil und Mittel (40) aufweist, welche in dem ebenen Teil aufgenommen sind, zum Verbinden erster Leiterbahnen (36), die auf der Oberfläche des ebenen Teils angeordnet sind mit zweiten Leiterbahnen (37), die an der gegenüberliegenden Oberfläche angeordnet sind, wobei die Leiterstreifen (41; 70) in Kontakt mit wenigstens einer Leiterbahn der ersten Leiterbahnen stehen, die verbunden ist mit einer Leiterbahn, unter der zweiten Leiterbahnen, die dafür vorgesehen ist mit einer Referenzspannungsquelle verbunden zu sein.

4. Vorrichtung nach Anspruch 1, wobei die Metallschichten (64, 66; 80, 82) wenigstens eine gemeinsame Wand besitzen.

5. Vorrichtung nach Anspruch 1, wobei die Metallschichten (64, 66; 80, 82) gegenüberliegende Wände besitzen.

6. Vorrichtung nach Anspruch 1, wobei der Träger (62) eine Kugelgitteranordnung ist.

7. Verfahren zum Herstellen eines elektronischen Schaltkreises (60), das folgende Schritte aufweist:
(a) Bereitstellen eines Wafers (30)
(b) Anbringen von Schaltkreisteilen (43, 44) an dem Wafer, wobei jeder wenigstens einen integrierten Schaltkreischip aufweist;
(c) Abdecken mit einer Isolierschicht (52);
(d) Ausbilden von Ausnehmungen (54; 70) in der Isolierschicht, welche jeden Schaltkreisteil umgeben und einen Isolationsblock (55; 77) begrenzen, der jeden Schaltkreisteil abdeckt;
(e) Abdecken der so erhaltenen Struktur mit einer Metallschicht (56; 79); und
(f) Begrenzen der elektronischen Schaltkreise, wobei jeder wenigstens zwei benachbarte Schaltkreisteile aufweist,
**dadurch gekennzeichnet, dass** Schritt (b) vorangehend oder gefolgt ist von einem Schritt des Ausbildens von Leiterstreifen (41; 70) auf dem Träger (30), der jeden Schaltkreisteil (43, 44) umgibt, wobei die Ausnehmungen (54; 70) im Schritt (d) ausgebildet werden, um die Leiterstreifen freizulegen, und wobei im Schritt (e) die Metallschicht (56; 79) in Kontakt mit den Leiterstreifen ist.

8. Verfahren nach Anspruch 7, wobei die Ausnehmungen (54; 70) durch Sägen ausgebildet sind.
